Europäisches Patentamt

European Patent Office

Office européen des brevets

(11) Publication number: **0 417 645 A1**

## EUROPEAN PATENT APPLICATION

(21) Application number: 90117178.5

(51) Int. Cl.5: **H01L 29/812**

(22) Date of filing: 06.09.90

The title of the invention has been amended (Guidelines for Examination in the EPO, A-III, 7.3).

(30) Priority: 06.09.89 JP 232377/89

(43) Date of publication of application:
20.03.91 Bulletin 91/12

(84) Designated Contracting States:
DE FR GB NL

(71) Applicant: SUMITOMO ELECTRIC INDUSTRIES, LTD.
5-33, Kitahama 4-chome, Chuo-ku
Osaka-shi, Osaka 541(JP)

(72) Inventor: Shiomi, Hiromu, c/o Itami Works of Sumitomo Elec.
Ind. Ltd., 1-1 Koyakita 1-chome, Itami-shi
Hyogo-ken(JP)
Inventor: Nishibayashi, Yoshiki, c/o Itami Works of Sumitomo
Elec. Ind. Ltd., 1-1 Koyakita 1-chome, Itami-shi
Hyogo-ken(JP)
Inventor: Fujimori, Naoji, c/o Itami Works of Sumitomo Elec.
Ind. Ltd., 1-1 Koyakita 1-chome, Itami-shi
Hyogo-ken(JP)

(74) Representative: Lehn, Werner, Dipl.-Ing. et al
Hoffmann, Eitle & Partner Patentanwälte
Arabellastrasse 4
W-8000 München 81(DE)

(54) MES field effect transistor formed in a diamond layer.

(57) An MES field effect transistor comprising a semiconductor layer (12) on a substrate (11) and metal electrode layers (13,14,15) on the semiconductor layer (12), in which the semiconductor layer (12) acting as an operating layer is a p-type or n-type semiconductor diamond layer. Such transistor is thermally resistant.

*Fig. 1*

## MES FIELD EFFECT TRANSISTOR

### BACKGROUND OF THE INVENTION

Field of the Invention

The present invention relates to a field effect transistor having a metal/semiconductor (MES) structure which is one of semiconductor devices.

Description of the Related Art

Currently, silicon (Si) is predominantly used as a semiconductor material. Si is used in semiconductor devices which constitute an integrated circuit such as a logic circuit or a semiconductor memory. Among the semiconductor devices, a metal oxide semiconductor (MOS) field effect transistor which can be easily highly integrated is used as the semiconductor memory, and a bipolar transistor is used as a logic operator device which is required to act at a high speed.

Besides, Si is used in various electronic devices such as an analog IC. A compound semiconductor such as GaAs or InP is being developed for specified applications such as an optical device and an ultra high speed IC.

However, Si cannot be used at a temperature of not lower than 200°C and GaAs cannot be used at a temperature of not lower than 300°C. This is because a carrier density increases since Si is intrinsic at the temperature of not lower than 200°C due to its narrow band gap of 1.1 eV, and GaAs is also intrinsic at the temperature of not lower than 300°C due to its narrow band gap of 1.5 eV.

By the way, an integration degree of the integrated circuit is recently increased more and more, and then the device highly tends to generate heat. Since the heat causes malfunction of the circuit, a way of dissipating the heat is sought.

Japanese Patent Kokai Publication Nos. 208821/1984 and 213126/1984 disclose epitaxial growth of a diamond film on single crystal diamond by a vapor deposition to prepare a semiconductor device. However, an MES semiconductor device is not disclosed in these Publications.

### SUMMARY OF THE INVENTION

An object of the present invention is to provide a field effect transistor which is thermally resistant and has an effective way of dissipating the heat.

This and other objects are achieved by an MES field effect transistor comprising a semiconductor layer on a substrate and metal electrode layers on the semiconductor layer, in which the semiconductor layer acting as an operating layer is a p-type or n-type semiconductor diamond layer.

### BRIEF DESCRIPTION OF THE DRAWINGS

Fig. 1 is a schematic sectional view of one embodiment of the MES field effect transistor according to the present invention,

Fig. 2 is a sectional view showing the preparation of the MES field effect transistor according to the present invention,

Figs. 3 to 5 are graphs showing transistor characteristic of the MES field effect transistor according to the present invention, and

Fig. 6 is a graph showing a relationship between the boron content and the resistivity of the semiconductor diamond.

### DETAILED DESCRIPTION OF THE INVENTION

It is well known that the diamond is epitaxially grown on the single crystal diamond to prepare a semiconductor device. However, in comparison with an Si semiconductor and a III-IV group semiconductor, the diamond semiconductor has poor properties and has many problems to be solved. In such circumstances, the present invention provides the diamond semiconductor which can be practically used.

The MES field effect transistor according to the present invention is usually a normally-on type transistor which has either p-type semiconductor layer or n-type semiconductor layer as the operating layer of one transistor. Plural transistors each having the p-type or n-type semiconductor layer as the operating layer may be formed on one substrate.

The MES field effect transistor according to the present invention preferably comprises the substrate made of a single crystal diamond which is natural or artificially synthesized in view of heat release effect. The substrate is preferably insulative. But, the substrate may be a p-type or n-type semiconductor single crystal diamond when the operating layer is n-type or p-type semiconductor diamond layer.

Preferably, the semiconductor diamond layer is formed by a vapor deposition method and contains at least one impurity selected from the group consisting of B, N, Al, P, S, Cl, As and Se. The semiconductor diamond layer contains the impurity in an amount of 0.01 ppm to 1 % by atomic ratio. The semiconductor diamond layer has a thickness of 0.05 to 10 $\mu$m.

The MES field effect transistor has a source electrode, a gate electrode and a drain electrode. The gate electrode is made of any substance which makes a schottky contact with the semiconductor diamond layer. For example, Au, Pt, Cu, Mo, W, Al, Ni, Fe, Co, Mn and carbides thereof can be used. The source electrode and the drain electrode are made of any substance which makes an ohmic contact with the semiconductor diamond layer. For example, Ti, Ta, Hf and carbides thereof can be used.

The MES field effect transistor according to the present invention can be prepared by a vapor deposition method which comprises mixing a carbon source gas with a diluting gas and an impurity source gas, decomposing and exciting a resultant mixture gas, introducing the gas on a substrate, and growing the semiconductor diamond layer on the substrate.

In order to form the semiconductor diamond layer in the above method, a feed gas which comprises the carbon source gas, the diluting gas and the impurity source gas is used. Specific examples of the carbon source gas are carbon-containing organic compounds, for example, methane, ethane and ethanol. Specific examples of the diluting gas are a hydrogen gas and/or an inert gas. The diluting gas is used in an amount of at least one mole per one mole of the carbon source gas. Specific examples of the impurity source gas are a single substance, a hydride, a halide and an organic metal compound of the desired impurity element. An amount of the impurity source gas is selected according to the desired doping amount of impurity in the semiconductor diamond.

In the vapor phase deposition for growing the diamond layer, a procedure for decomposing and exciting the feed gas includes 1) a method comprising activating the feed gas by heating a thermoionic emission material to a temperature of at least 1500$^\circ$K, 2) a method which utilizes a discharge from a direct current, high frequency or microwave electric field, 3) a method which utilizes an ion collision and 4) a method comprising applying light such as laser. Any of these methods can be used, but methods 1), 2) and 4) give good semiconductor crystal diamond. The substrate on which the decomposed and excited feed gas is introduced is preferably heated to a temperature of at least 400$^\circ$C.

A dry etching method utilizing oxygen plasma can give a fine pattern on the diamond. As the dry etching method utilizing oxygen plasma, a plasma etching method utilizing parallel plate electrodes or an ion beam etching method can be used.

With reference to the attached drawings, the MES field effect transistor according to the present invention is explained. The present invention is not limited to the embodiments of the attached drawings.

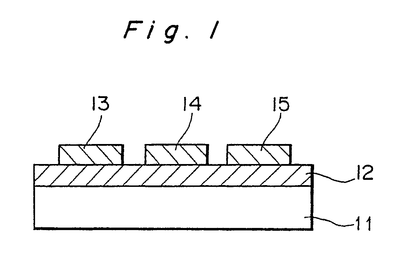

Fig. 1 is a schematic sectional view of one embodiment of the MES field effect transistor according to the present invention. This field effect transistor has an insulative single crystal diamond substrate 11, a semiconductor diamond layer 12, a source metal electrode 13, a gate metal electrode 14 and a drain metal electrode 15. The semiconductor diamond layer 12 is made of p-type or n-type semiconductor diamond. The parts of the semiconductor diamond layer 12 (excluding the part under the gate electrode 14) which are in contact with the source metal electrode 13 and the drain metal electrode 15, preferably have a higher impurity concentration.

Since the diamond has a wide band gap of 5.5 eV, the temperature range which corresponds to the intrinsic range of the diamond does not include temperatures of not higher than 1400$^\circ$C at which the diamond is thermally stable. The diamond has high chemical stability. Thus, the device made from the diamond can operate at an elevated temperature, and has good environmental resistance. The diamond has a thermal conductivity of 20 [W/cm$\cdot^\circ$k] which is 10 times larger than that of Si, and good heat dissipation. In addition, the diamond has large carrier mobility (electron mobility: 2000 [cm$^2$/V$\cdot$sec], hole mobility: 2100 [cm$^2$/V$\cdot$sec] at 300 $^\circ$K), a small dielectric constant (K = 5.5), large electrical field at breakdown (E$_B$ = 5 x 10$^6$ V/cm), etc. Thus, the diamond has possibility to be used as a material for a device to act at a high frequency and large wattage.

Since the diamond is insulative when it contains no impurity, perfect electrical separation of the diamond substrate from the diamond operating layer can be advantageously achieved when the MES field effect transistor is made.

Generally, the MES field effect transistor can be made through simple manufacturing steps and can be integrated easily in comparison with a bipolar transistor. Among the MES field effect transistors, a normally-on type MES field effect transistor has an advantage in that it can be prepared through simple manufacturing steps, since it has a simple structure.

The MES field effect transistor of the present invention has good thermal resistance and environmental resistance, and can be used in a harsh environment such as in an engine room of automobile, a nuclear reactor or an artificial satellite.

Since the field effect transistor according to the present invention can be easily highly integrated because of good thermal conductivity of the diamond, it can be used as a thermally resistant high speed logic operator device or a high-frequency large-output device.

The characteristics of the present invention are further explained. The first characteristic of the present invention is that the epitaxial growth of the diamond is extremely easy since the substrate is made of the diamond. Thermal conductivity of the diamond substrate is sufficiently utilized. The diamond semiconductor is characterized in the stable operation at a high temperature. Since the substrate and the semiconductor layer are made of the diamond, the present invention provides the MES field effect transistor in which no exfoliation due to mismatch of thermal expansion coefficient is caused by the heat cycle.

Further characteristic of the present invention is that the structure of the transistor is simple since the transistor is the MES semiconductor device.

In the course of our study, we found that it is very difficult to keep the electrical resistance of the n- type diamond in a practical level.

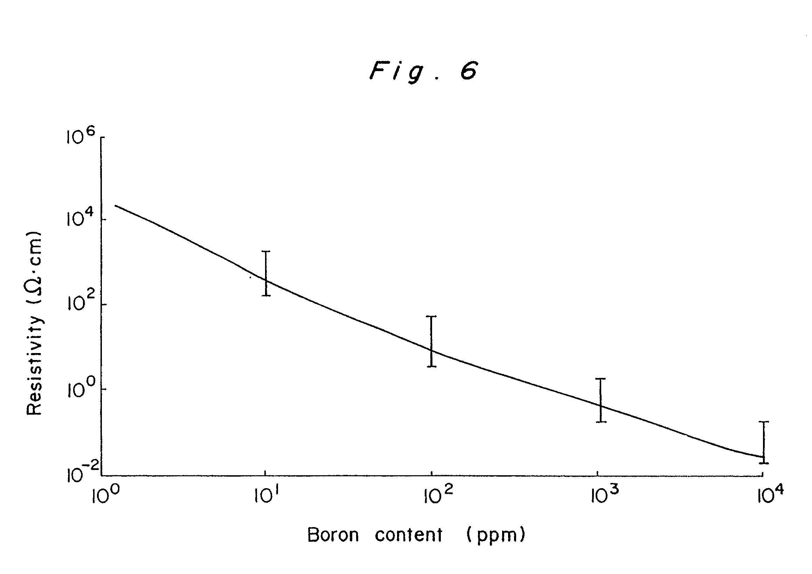

In our study, the p-type diamond having the electrical resistance in the practical level can be prepared. It is found that the diamond containing 0.1 to 1000 ppm by atomic ratio of boron has good resistivity of smaller than 1000 ohm·cm. When the boron content is 10 to 500 ppm by atomic ratio, the semiconductor diamond having the resistivity of smaller than several ohm·cm, e.g. 3 ohm·cm can be prepared. When the boron content is lower than 0.1 ppm, the resistivity is too high. When the boron content is higher than 1000 ppm, the diamond cannot be utilized as the semiconductor since the diamond exhibits metallic properties. A relationship between the boron content and the resistivity of the semiconductor diamond is shown in Fig. 6.

Boron is doped preferably during the vapor deposition. An ion implantation method is not preferable since turbulence of crystal lattice is large and the semiconductor properties are not exhibited even after annealing.

The MES field effect transistor according to the present invention preferably has the p-type semiconductor diamond layer.

Now, the present invention is explained by the following examples.

Example 1

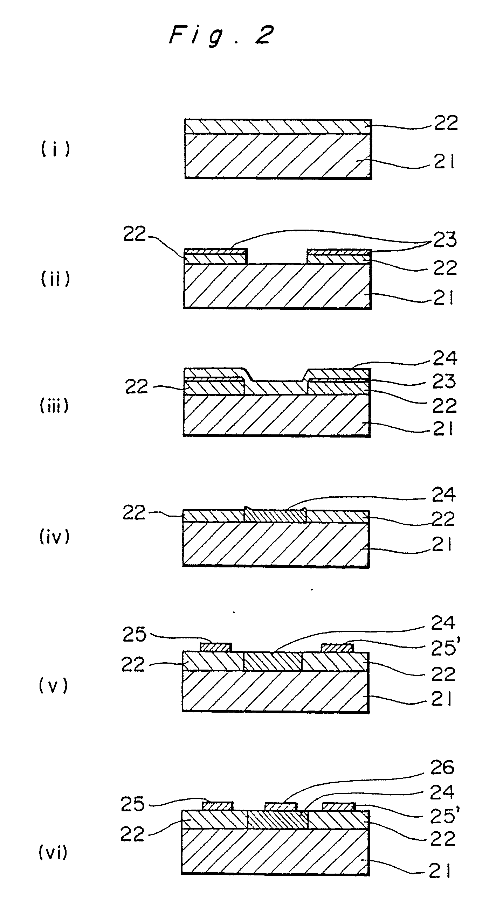

An MES field effect transistor comprising a diamond was prepared by a procedure shown in Fig. 2.

(i) By a conventional microwave plasma CVD method, a boron highly doped p-type diamond thin layer 22 having a thickness of 0.5 $\mu$m was formed on the (100) plane of a substrate 21 of Ib type artificially synthesized single crystal diamond having a size of 3 x 2 x 1 mm. The growing conditions were as follows:
Microwave power: 300 W
Reaction pressure: 40 torr
Feed gas: $CH_4$ (6 %) + $B_2H_6$ (0.001 %) + $H_2$ - (remainder)

(ii) On parts of the p-type diamond thin layer, chromium was deposited as a mask 23. A part of the p-type diamond thin layer on which no mask was formed was removed by an oxygen plasma etching. The etching conditions were as follows:
R.F. power (high frequency output): 200 W
Pressure: 0.005 torr

(iii) Without removing the Cr mask 23, a boron doped p-type diamond thin layer 24 having a thickness of 0.5 $\mu$m was formed by a microwave plasma CVD method. The growing conditions were as follows:
Microwave power: 300 W
Reaction pressure: 40 torr
Reaction gas: $CH_4$ (6%) + $B_2H_6$ (0.00005 %) + $H_2$ (remainder)

(iv) The Cr mask 23 was dissolved with aqua regia and parts of the p-type diamond thin layer 24 were removed by a lift-off method.

(v) An Au/Mo/Ti three layer electrode was deposited, and then parts of it were etched to form a source ohmic electrode 25 and a drain ohmic electrode 25'.

(vi) After depositing an Al layer, parts of it were etched to form a gate electrode 26.

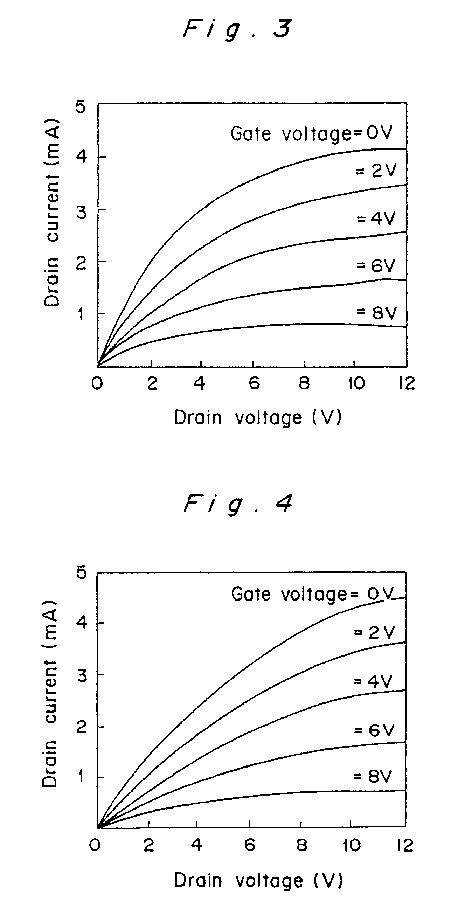

A characteristic of the MES field effect transistor thus formed was measured. A transistor characteristic shown in Fig. 3 was observed even at 600° C.

Example 2

Example 1 was repeated except that the B-doped p-type diamond thin layer 24 was formed in place of the boron highly doped p-type diamond thin layer 22 which was formed in the step (i) and the electrodes 25, 25' and 26 were formed on the diamond thin layer 24. A characteristic of the MES field effect transistor thus formed was measured. A transistor characteristic shown in Fig. 4 was observed even at 600° C.

Example 3

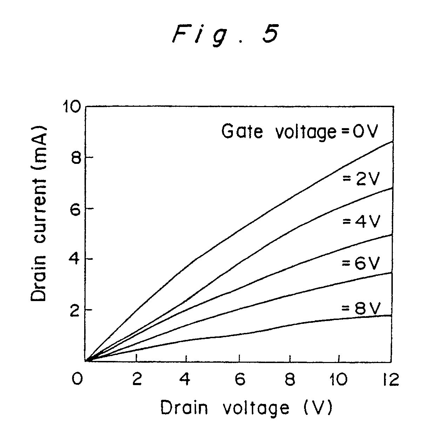

Example 1 was repeated except that tungsten was used in place of aluminum for the gate electrode 26. A characteristic of the MES field effect transistor thus formed was measured. A transistor characteristic shown in Fig. 5 was observed even at 800 °C.

## Claims

1. An MES field effect transitor comprising a semiconductor layer on a substrate and metal electrode layers on the semiconductor layer, in which the semiconductor layer acting as an operating layer is a p-type or n-type semiconductor diamond layer.

2. The MES field effect transistor according to claim 1, in which the substrate is made of a single crystal diamond.

3. The MES field effect transistor according to claim 1, in which the substrate is made of an insulative diamond.

4. The MES field effect transistor according to claim 1, in which the substrate is made of an n-type or p-type semiconductor diamond.

5. The MES field effect transistor according to claim 1, in which the semiconductor diamond layer contains at least one impurity selected from the group consisting of B, N, Al, P, S, Cl, As and Se.

6. The MES field effect transistor according to claim 5, in which the semiconductor diamond layer contains the impurity in an amount of 0.01 ppm to 1 % by atomic ratio.

7. The MES field effect transistor according to claim 1, in which the semiconductor diamond layer has a thickness of 0.5 to 10 $\mu$m.

Fig. 1

# Fig. 2

(i)

(ii)

(iii)

(iv)

(v)

(vi)

Fig. 3

Fig. 4

# Fig. 5

Fig. 6

EP 0 417 645 A1

<table>
<tr><td colspan="2">European Patent Office</td><td>EUROPEAN SEARCH REPORT</td><td>Application Number</td></tr>
</table>

**European Patent Office**

**EUROPEAN SEARCH REPORT**

Application Number

**EP 90 11 7178**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-3 818 719 (SUMITOMO ELECTRIC INDUSTRIES) * Page 3, lines 30-35; page 4, lines 49-52; abstract * | 1,5,6 | H 01 L 29/812 |
| A | APPLIED PHYSICS LETTERS, vol. 53, no. 7, 15th August 1988, pages 586-588, American Institute of Physics, New York, NY, US; G.Sh. GILDENBLAT et al.: "Electrical characteristics of Schottky diodes fabricated using plasma assisted chemical vapor deposited diamond films" * Whole document * | 1 | |
| P,X | JAPANESE JOURNAL OF APPLIED PHYSICS, vol. 28, no. 12, part 2, December 1989, pages L2153-L2154, Tokyo, JP; H. SHIOMI et al.: "Field-effect transistors using boron-doped diamond epitaxial films" * Whole document * | 1-4 | |

| | TECHNICAL FIELDS SEARCHED (Int. Cl.5) |
|---|---|
| | H 01 L |

The present search report has been drawn up for all claims

| Place of search | Date of completion of search | Examiner |
|---|---|---|
| The Hague | 19 December 90 | BAILLET B.J.R. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document